# EUROPEAN PATENT APPLICATION

(11) **EP 1 587 052 A2**
(43) Date of publication of application: **19.10.2005**
(21) Application number: 05007622.3
(22) Date of filing: 07.04.2005
(51) Int. Cl.: G09G 3/28

(54) **Plasma display apparatus and method of driving thereof**

(30) Priority: 12.04.2004 KR 2004024846
(71) Applicant: LG ELECTRONICS INC., Seoul, 150-721 (KR)
(72) Inventor: Choi, Jeong Pil, Gwonseon-gu Suwon-si Gyeonggi-do (KR)
(74) Representative: Vetter, Ewald Otto

(57) **Abstract**

A plasma display apparatus of the present invention comprises a controlling unit for converting image signals into data to be displayed and generating clock signals for synchronizing the data; a data driving unit for generating an address pulse by using the data and the clock signals; and a transmision unit for floating the data and the clock signals from the controlling unit to transmit the data and the signals to the data driving unit.

## Description

This Nonprovisional application claims priority under 35 U.S.C. § 119(a) on Patent Application No. 10-2004-0024846 filed in Korea on April 12, 2004, the entire contents of which are hereby incorporated by reference.

### BACKGROUND OF THE INVENTION

### Field of the Invention

The present invention relates to a plasma display apparatus, and more particularly to a Plasma Display Apparatus and Driving Method which improves a driving efficiency.

### Description of the Background Art

Generally, in a plasma display apparatus, a barrier rib between a front substrate and a rear substrate forms a unit cell, wherein main discharge gas such as Ne, He or mixure gas of Ne and He and an inert gas including a small amount of Xenon. In case of a discharge caused by a high frequency voltage, the inert gas generates vacuum ultraviolet rays and allows a fluorescent substance between the barrier ribs to radiate light. Such plasma display panel is popular as a new generation display apparatus due to its thin and light structure.

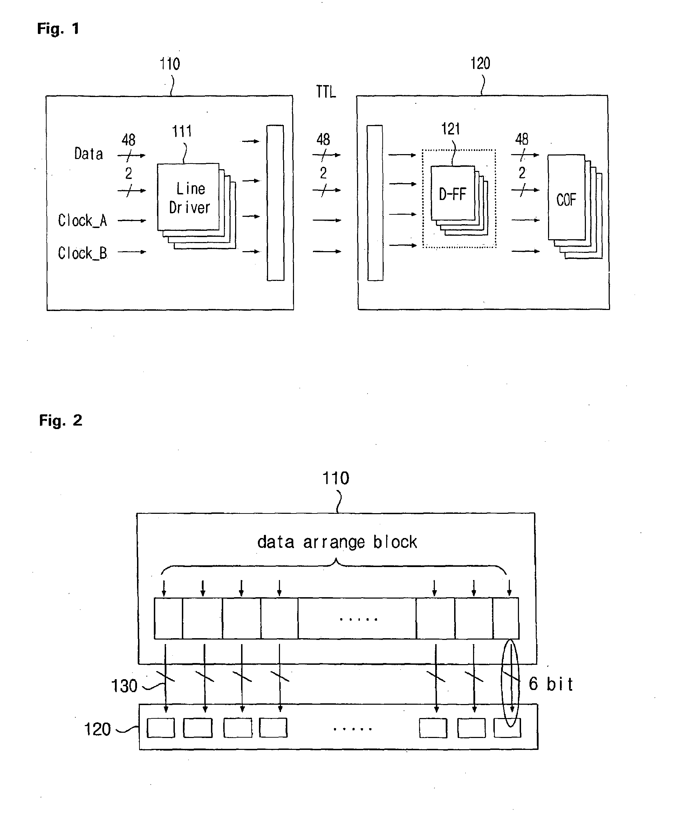

Fig. 1 is a diagram of describing a prior art plasma display apparatus.

As shown in Fig. 1, the plasma display apparatus comprises a controlling unit 110 for converting image signals into data to be displayed and generating clock signals for synchronizing the data; and a data driving unit 120 for receiving the data and the clock signals from the controlling unit 110 to generate address pulses.

The controlling unit 110 amplifies clock signals and data by a line driver 111, and then transmits the signals and data at a voltage of 5 V (TTL level).

Here, a transfer rate of data is twice as fast as the clock rate, and so data bus requires 48 bits, which is a half of 96 bits.

The data driving unit 120 detects desired data by clocking data in each D flip-flop 121 according to the clock signals.

In addition, the unit writes addressing pulses, which are generated from the detected data, on address electrodes to display the same. Here, the prior plasma display apparatus is shown in Fig. 2 to Fig. 4 in more detail.

Fig. 2 is a diagram of describing a method of transmitting data of the prior art plasma display apparatus.

As shown in Fig.2, the prior art plasma display apparatus transfers data by a method of parallel transmission. For example, in a case of the plasma display apparatus having a resolution of WVGA(852×480), the data driving unit 120 generally signal-proceeds with 96 pin out and 6 bit in. Therefore, a transmision unit between the controlling unit 110 and the data driving unit 120 requires 160 transfer lines, that is 852×3(R, G, B)÷96 pin×6 bit ≒ 160 transfer lines.

Like this, the prior art plasma display apparatus requires high costs for manufacture. That is, the controlling unit 110 requires an appropriate line driver 111 for many data. The data driving unit 120 requires the d-flipflop 121 for eliminating noise. In addition, in an interface between the controlling unit 110 and the data driving unit 120, there should be many transfer lines 130 as data increases.

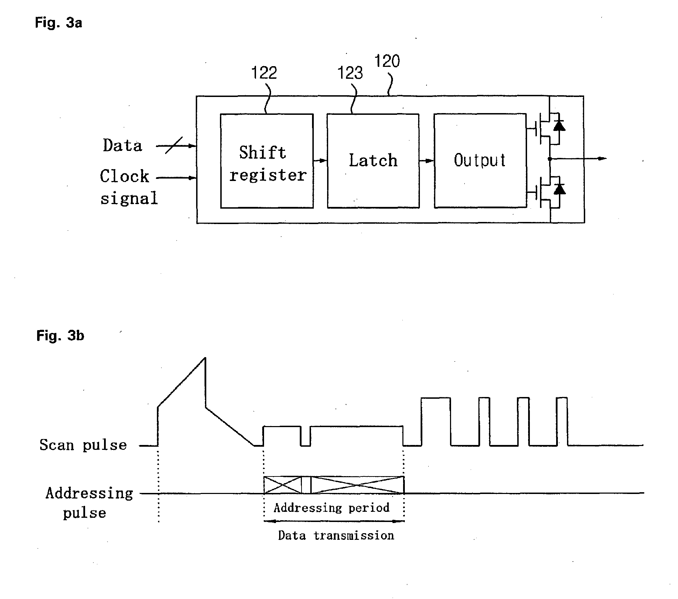

Fig. 3a is a diagram for illustrating the data driving unit of the prior art plasma display apparatus, and Fig. 3b is a waveform of showing a driving pulse of the prior art plasma diplay apparatus.

As shown in Fig. 3a and Fig. 3b, in the prior art, data and clock signals are transmitted from the controlling unit to the data driving unit 120 every address period. The data driving unit 120 adjusts 96 pin out, data and clock signals by using a shift register 122 and then outputs the data and the clock signals through a latch 123.

This prior art data driving unit 120 transmits small signal in the addressing period during a high voltage discharge, thereby making a noise. In addition, the prior art data driving unit has a problem in that the addressing period is shorter as a resolution is higher, causing a time limitation.

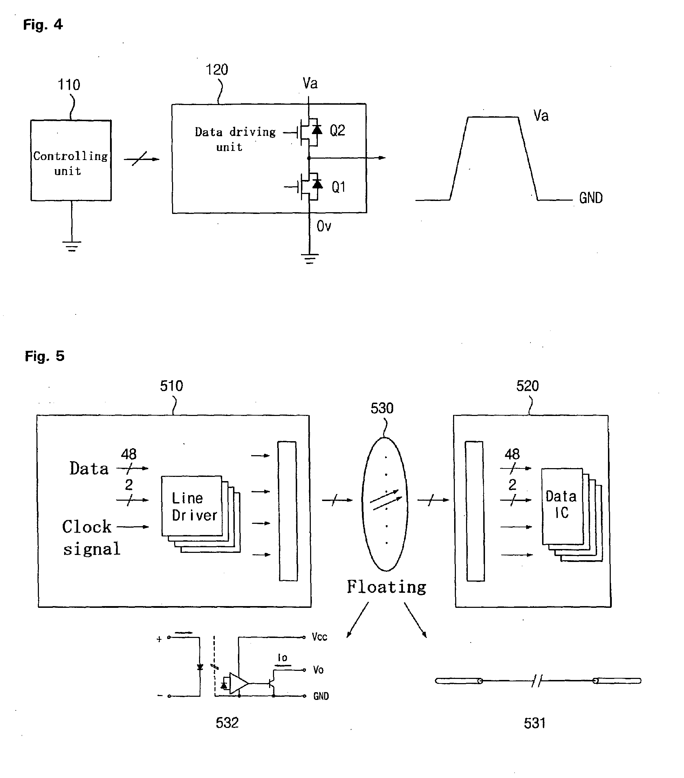

Fig. 4 is a diagram for describing an addressing pulse generated in the prior art data driving unit.

As shown in Fig. 4, data and clock signals inputted from the controlling unit 110 results in an addressing pulse of Va voltage through the data driving unit 120. The data driving unit 120 includes a switch Q1 applying a base voltage 0 V and a switch Q2 applying a voltage Va. Here, a condition of withstanding voltage of the switches Q1 and Q2 should be higher than the voltage Va, and so the data driving unit uses expensive switches to cause high costs for manufacture.

In addition, as the plasma display apparatus is large sized nowadays, a data transmition distance of the controlling unit and the data driving unit becomes longer, causing data loss and a delay difference of clock signals and data according to the transmission distance and causing a trouble of adjusting the difference.

In addition, since data and clock signals are transmitted at a high rate of 5V (TTL Level), the apparatus cause a problem of Electro Magnetic Interference.

### SUMMARY OF THE INVENTION

Accordingly, an object of the present invention is to solve at least the problems and disadvantages of the background art.

An object of the present invention is to provide a plasma display apparatus which can decrease withstanding voltage of the data driving unit and also increase the driving margin.

In addition, another object of the present invention is to provide a plasma display apparatus which can suppress data loss and noise in transmitting data.

In addition, another object of the present invention is to provide a plasma display apparatus which can reduce the unit cost of production.

A plasma display apparatus of the present invention comprises a controlling unit for converting image signals into data to be displayed and generating clock signals for synchronizing the data; a data driving unit for generating an address pulse by using the data and the clock signals; and a transmision unit for floating the data and the clock signals controlled by the controlling unit to transmit the data and the signals to the data driving unit.

The plasma display apparatus of the present invention has an effect to decrease withstanding voltage of the data driving unit and also to increase the driving margin.

In addition, the plasma display apparatus of the present invention has an effect to suppress data loss and noise in transmitting data.

In addition, the plasma display apparatus of the present invention can reduce the unit cost of production.

### BRIEF DESCRIPTION OF THE DRAWINGS

The invention will be described in detail with reference to the following drawings in which like numerals refer to like elements.

Fig. 1 is a diagram of describing a prior art plasma display apparatus.

Fig. 2 is a diagram of describing a method of transmitting data of the prior art plasma display apparatus.

Fig. 3a is a diagram for illustrating the data driving unit of the prior art plasma display apparatus, and Fig. 3b is a waveform of showing a driving pulse of the prior art plasma diplay apparatus.

Fig. 4 is a diagram for describing an addressing pulse generated in the prior art data driving unit.

Fig. 5 is a diagram of describing a plasma display apparatus according to an embodiment of the present invention

Fig. 6 is a diagram of describing a data transfer method of the plasma display apparatus of the embodiment of the present invention.

Fig. 7a and Fig. 7b are diagrams of illustrating the data driving unit of the plasma display apparatus of an embodiment of the present invention.

Fig. 8 is a waveform of showing a driving pulse of the plasma display apparatus of the embodiment of the present invention.

Fig. 9 is a diagram of describing an addressing pulse which is generated in the plasma display apparatus of an embodiment of the present invention.

Fig. 10 is a waveform of a driving pulse according to another embodiment of the present invention.

Fig. 11 is a diagram of showing the plasma display apparatus of an embodiment of the present invention.

### DETAILED DESCRIPTION OF PREFERRED EMBODIMENTS

Preferred embodiments of the present invention will be described in a more detailed manner with reference to the drawings.

The plasma display apparatus according to an aspect of the present invention comprises a controlling unit for tranforming image signals from external into data for displaying, and for generating clock signals for synchronizing the data; a data driving unit for generating an address pulse by using the data and the clock signals; and a transmision unit for floating the data and the clock signals controlled by the controlling unit, and transmitting the data and the clock signals to the data driving unit.

The transmision unit uses one of both an optic fiber and a photo coupler.

The transmision unit transmits the data and the clock signals in a differential signal method.

The transmision unit assigns a plurality of data driving lines to one transfer line of the controlling unit to transmit the data and clock signals.

The apparatus further comprising a storing unit for temporarily storing the data and clock signals transmitted from the transmision unit and for transmitting the data and clock signals to the data driving unit.

The transmision unit transmits the data and the clock signals to the storing unit during arbitrary period of the entire frame.

The arbitrary period is one of reset period or sustain period.

The one of positive voltage or negative voltage is applied to a base port of the data driving unit.

A first voltage having positive polarity is applied to the base port, wherein the address pulse is generated by applying a second voltage which is a difference voltage between the Va voltage and the first voltage to Va supplying unit which generates the Va voltage for address discharge.

A voltage having negative polarity is applied to the base port during the reset period.

A plasma display apparatus according to another aspect of the present invention comprises a controlling unit for tranforming image signals from external into data for displaying, and for generating clock signals for synchronizing the data; a data driving unit for generating an address pulse by using the data and the clock signals; and a transmission unit for transforming the data and the clock signals from a first base voltage to a second base voltage, and transmitting-the transformed data and clock signals to the data driving unit.

A method for driving plasma display apparatus according to another aspect of the present invention comprises a controlling step of transforming image signals from external into data for displaying, and generating clock signals for synchronizing the data; a transmitting step of floating the data and clock signals controlled in the controlling step, and transmiting the data and clock signals; and a data driving step of generating an address pulse by using the transmitted data and clock signals.

One of both an optic fiber and a photo coupler is used in the transmitting step.

The data and the clock signals are tranmitted in a differential signal method in the transmitting step.

A plurality of data driving lines are assigned to one transfer line of the controlling unit to transmit the data and clock signals in the transmitting step.

The method further comprises a storing step of temporarily storing the data and clock signals transmitted from the transmision unit, and of transmitting the data and clock signals to the data driving step.

The data and the clock signals are transmitted to the storing step during arbitrary period of the entire frame.

The arbitrary period is one of reset period or sustain period.

One of positive voltage or negative voltage is applied to a base port.

A first voltage having positive polarity is applied to the base port, wherein the address pulse is generated by applying a second voltage which is a difference voltage between the Va voltage and the first voltage to Va supplying unit which generates the Va voltage for address discharge.

A voltage having negative polarity is applied to the base port during the reset period.

A method for driving plasma display apparatus according to another aspect of the present invention comprises a step of transforming image signals from external into data for displaying, and generating clock signals for synchronizing the data; a step of transforming the data and the clock signals from a first base voltage to a second base voltage, and transmitting the transformed data and clock signals; and a step of data driving for generating an address pulse by using the transformed data and clock signals which are the second base voltage.

Hereinafter, embodiments of the present invention will be described with reference to the following drawings.

Fig. 5 is a diagram of describing a plasma display apparatus according to an embodiment of the present invention

As shown in Fig. 5, the plasma display apparatus of the present invention comprises a controlling unit 510, a data driving unit 520, and a transmision unit 530.

The controlling unit 510 converts image signals inputted from an exterior into data to be displayed, and generates clock signals for synchronizing the data.

The data driving unit 520 processes the data and the clock signals inputted from the controlling unit 510 to generate addressing pulses.

The transmision unit 530 transmits data and clock signals from the controlling unit 510 to the data driving unit 520.

The transmision unit 530 of an embodiment of the present invention floats the data and the clock signals to change a ground level of the transmitted data.

That is, the transmission unit 530 according to an embodiment of the present invention is able to transmit data and clock signals between the control unit 510 and the data driving unit 520 in which a base voltage is different each other, when the control unit 510 uses a first base voltage, and the data driving unit 520 uses a second base voltage as a ground level which is different with the first base voltage in voltage level.

In an embodiment of the present invention, any one of an optical fiber 531 and a photo coupler 532 can be used as the transmision unit 530 in order to float the data and the clock signals. The optical fiber or the photo coupler is a means to change an electric signal to a light signal. Accordingly, the data and the clock signals are transformed into light signals and transmitted in a floating state, wherein an idea of the ground level is not necessary. In addition, the plasma display apparatus of an embodiment of the present invention transmits data and clock signals in a floating state at a relative voltage by using a differential signal method (not shown).

Like this, any one of the optical fiber, the photo coupler or the differential signal method can be used to float the data and the clock signals. In addition, these may be used together.

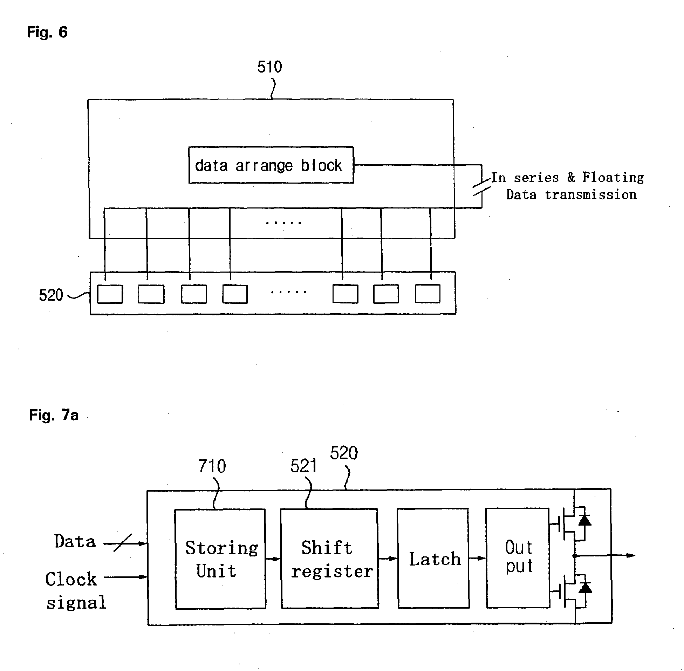

Here, the plasma display apparatus of an embodiment of the present invention is shown in Fig. 6 to Fig. 9 in more detail.

Fig. 6 is a diagram of describing a data transfer method of the plasma display apparatus of the embodiment of the present invention.

As shown in Fig.6, the plasma display apparatus of the embodiment of the present invention transmits data and clock signals in series. As described in Fig. 3, in the prior art data transfer method, the plasma display apparatus of WVGA resolution requires 160 lines.

In an embodiment of the present invention, the data transfer between the controlling unit 510 and the data driving unit 520 is made in series in order to reduce the number of data transfer lines. The serial transfer means transmitting data by assigning at least two lines of the data driving unit 520 to one transfer line of the controlling unit 510. By reducing the number of the transfer lines through the serial transfer, the number of the optical fiber and the photo coupler for floating can be minimized.

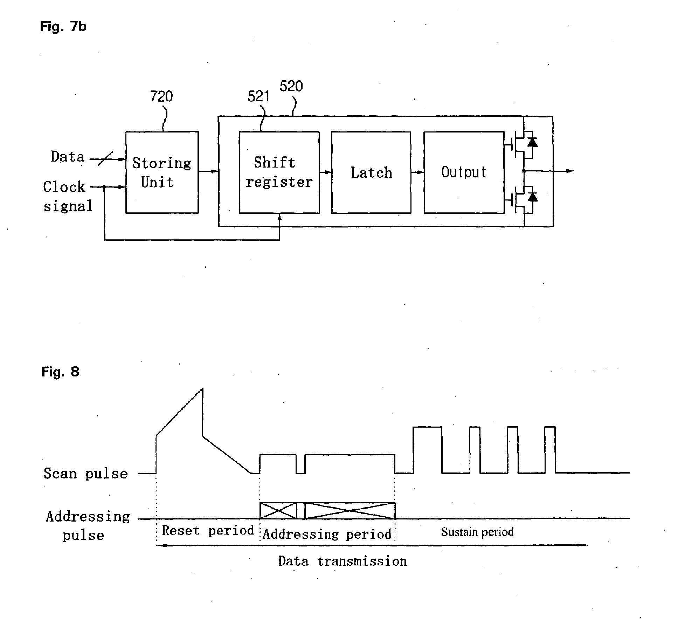

Meantime, the prior art data driving unit 120 in Fig. 3a and Fig. 3b has many problems since the data and the clock signals are transmitted during an addressing period. In addition, in the serial transmission of the present invention, the amount of data that can be transmitted per second is lower than in the prior art parallel transmission. Accordingly, in an embodiment of the present invention, data is transmitted in any period of the entire frame by including a storing unit as shown in Fig. 7.

Fig. 7a and Fig. 7b are diagrams of illustrating the data driving unit of the plasma display apparatus of the embodiment of the present invention.

As shown in Fig. 7a and Fig. 7b, the plasma display apparatus of the present invention further includes a storing unit 710 or 720 which temporarily stores data and clock signals inputted from the transmision unit 530 and transmits the data and clock signals to the data driving unit 520.

That is, the storing unit 710 is included in the data driving unit 520 as shown in Fig. 7a, or the storing unit 720 is included outside of the data driving unit 520 as shown in Fig. 7b. Here, data and clock signals which are temporarily stored in the storing unit 710, 720 are transmitted to the data driving unit 520 in any necessary time.

Fig. 8 is a waveform of showing a driving pulse of the plasma display apparatus of the embodiment of the present invention.

As shown in Fig. 8, an embodiment of the present invention further includes the storing unit 710, 720 to transmit data and clock signals to the data driving unit in arbitrary period of the entire frame. That is, the present invention can transmit data in one of a reset period or a sustain period as well as in an addressing period to overcome time limitation and to perform a stable operation.

In addition, in an embodiment of the present invention, arbitrary voltage level may be applied to a base port of data driving unit according to the transmission of data and clock signals which are in floating state to the data driving unit. That is, one of positive polarity or negative polarity voltage is applied to the base port of data driving unit when it is necessary.

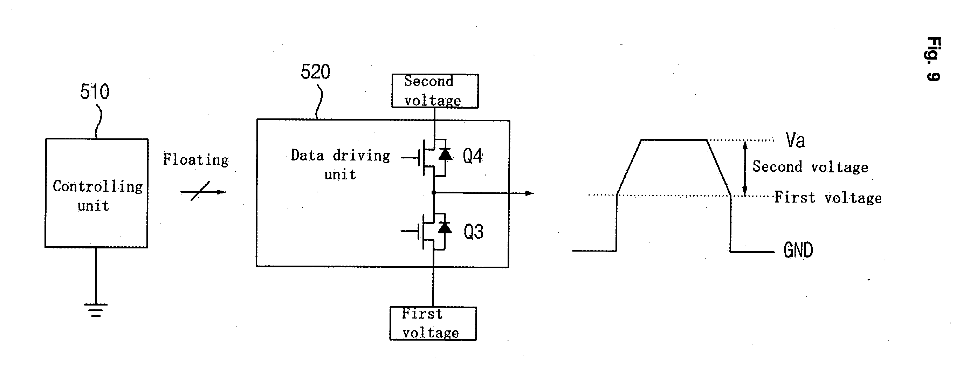

Fig. 9 is a diagram of describing an addressing pulse which is generated in the plasma display apparatus of an embodiment of the present invention.

As shown in Fig.9, the data driving unit 520 generates an addressing pulse of Va volt in the address period according to data and clock signals which are controlled in the controlling unit 510. Here, unlike the prior art data driving unit 120 of the above Fig. 4, a first voltage having positive polarity is applied to a base port switch Q3, while a second voltage which is a difference of the voltage Va and the first voltage is applied to a switch Q4 of Va supplying port which generates voltage Va for addressing discharge.

Accordingly, the switches Q3, Q4 can lower the withstanding voltage condition in the second voltage to improve a withstanding voltage characteristic.

According to another embodiment of the present invention, a minus voltage -Va is applied at an address electrode by controlling the floating data and clock signals.

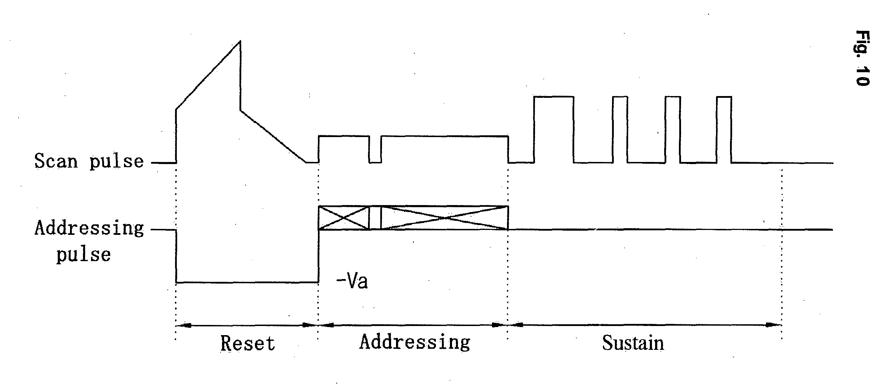

Fig. 10 is a waveform of a driving pulse according to a transformed example of an embodiment of the present invention.

As shown in Fig. 10, according to a transformed example -of an embodiment of the present invention, a negative polarity voltage may be applied to the address electrode according to data and clock signals controlled by the control unit. For instance, a negative polarity voltage -Va is applied to the base port in the reset period according to signals controlled by the control unit, when a strong discharge between the address electrode and the scan electrode is necessary in reset period, thereby facilitating a design for the driving pulse and increasing a driving margin.

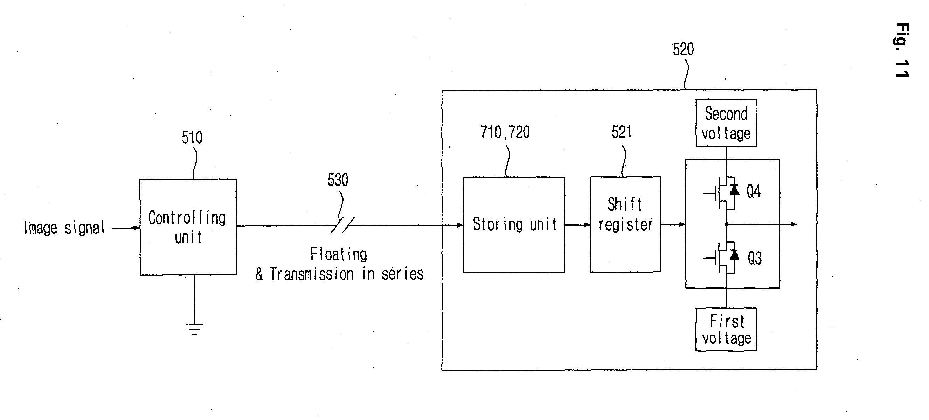

Fig. 11 is a diagram of showing the plasma display according to an embodiment of the present invention.

As shown in Fig. 11, the driving apparatus of the present invention floats data and clock signal by using a differential signal method or by the transfering unit 530 such as the optical fiber or the photo coupler, thereby adjusting a ground level. Here, in order to reduce the number of transfer-lines of the transmitting unit, a plurality of data driving lines are assigned to one transfer line of the controlling unit to transmit the data and clock signals.

In addition, the present invention includes the storing unit 710, 720 to overcome the time limitation and to obtain a stable transmission. Here, the present invention may use any one of the storing unit 710 in the data driving unit 520 and the storing unit 720 outside of the data driving unit 520, thereby controlling a data transfer period.

In addition, the data driving unit 520 can control an output voltage according to the data and the clock signal having a changed ground level, thereby improving the withstanding voltage characteristic and increasing the margin of driving.

The invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A plasma display apparatus comprising:
a controlling unit for tranforming image signals from external into data for displaying, and for generating clock signals for synchronizing the data;
a data driving unit for generating an address pulse by using the data and the clock signals; and
a transmision unit for floating the data and the clock signals controlled by the controlling unit , and transmitting the data and the clock signals to the data driving unit.

2. The apparatus of claim 1, wherein the transmision unit uses one of both an optic fiber and a photo coupler.

3. The apparatus of one of claim 1 or claim 2, wherein the transmision unit transmits the data and the clock signals in a differential signal method.

4. The apparatus of claim 1, wherein the transmision unit assigns a plurality of data driving lines to one transfer line of the controlling unit to transmit the data and clock signals.

5. The apparatus of claim 1, further comprising a storing unit for temporarily storing the data and clock signals transmitted from the transmision unit and for transmitting the data and clock signals to the data driving unit.

6. The apparatus of claim 5, wherein the transmision unit transmits the data and the clock signals to the storing unit during arbitrary period of the entire frame.

7. The apparatus of claim 6, wherein the arbitrary period is one of reset period or sustain period.

8. The apparatus of claim 1, wherein one of positive voltage or negative voltage is applied to a base port of the data driving unit

9. The apparatus of claim 8, wherein a first voltage having positive polarity is applied to the base port, wherein the address pulse is generated by applying a second voltage which is a difference voltage between the Va voltage and the first voltage to Va supplying unit which generates the Va voltage for address discharge.
The apparatus of claim 7, wherein a voltage having negative polarity is applied to the base port during the reset period.

10. A plasma display apparatus comprising:
a controlling unit for tranforming image signals from external into data for displaying, and for generating clock signals for synchronizing the data;
a data driving unit for generating an address pulse by using the data and the clock signals;
and a transmission unit for transforming the data and the clock signals from a first base voltage to a second base voltage, and transmitting the transformed data and clock signals to the data driving unit.

11. A method for driving plasma display apparatus, comprising:
a controlling step of transforming image signals from external into data for displaying, and generating clock signals for synchronizing the data;
a transmitting step of floating the data and clock signals controlled in the controlling step, and transmiting the data and clock signals; and
a data driving step of generating an address pulse by using the transmitted data and clock signals.

12. The method of claim 12, wherein one of both an optic fiber and a photo coupler is used in the transmitting step.

13. The method of claim 12 or claim 13, wherein the data and the clock signals are tranmitted in a differential signal method in the transmitting step.

14. The method of claim 12, wherein a plurality of data driving lines are assigned to one transfer line of the controlling unit to transmit the data and clock signals in the transmitting step.

15. The method of claim 12, further comprising a storing step of temporarily storing the data and clock signals transmitted from the transmision unit, and of transmitting the data and clock signals to the data driving step.

16. The method of claim 16, wherein the data and the clock signals are transmitted to the storing step during arbitrary period of the entire frame.

17. The method of claim 17, wherein the arbitrary period is one of reset period or sustain period.

18. The method of claim 12, wherein one of positive voltage or negative voltage is applied to a base port.

19. The method of claim 19, wherein a first voltage having positive polarity is applied to the base port, wherein the address pulse is generated by applying a second voltage which is a difference voltage between the Va voltage and the first voltage to Va supplying unit which generates the Va voltage for address discharge.

20. The method of claim 19, wherein a voltage having negative polarity is applied to the base port during the reset period.

21. A method for driving plasma display apparatus, comprising:
a control step of transforming image signals from external into data for displaying, and generating clock signals for synchronizing the data; and
a transmission step of transmitting the data and clock signals which are controlled in the control step in which a first base voltage is used to a data driving step in which a second base voltage that is different wth the first base voltage in voltage level is used,
wherein, in the data driving step, an address pulse is generated by using the data and clock signals.
